# EUROPEAN PATENT APPLICATION

(11) **EP 4 561 280 A1**
(43) Date of publication of application: **28.05.2025**
(21) Application number: 23890114.4
(22) Date of filing: 25.05.2023
(51) Int. Cl.: H05K 7/20

(54) **SIPHON COOLER AND FIN THEREOF**

(30) Priority: 15.11.2022 CN 202211429081
(71) Applicant: Guangdong Envicool Technology Co., Ltd., Sanjiao Town, Zhongshan Guangdong 528400 (CN)
(72) Inventor: CHEN, Dong, Zhongshan, Guangdong 528400 (CN); XIONG, Zhen, Zhongshan, Guangdong 528400 (CN); ZHANG, Jing, Zhongshan, Guangdong 528400 (CN)
(74) Representative: Torggler & Hofmann Patentanwälte - Innsbruck
(86) International application number: PCT/CN2023/096210
(87) International publication number: WO 2024/103670

(57) **Abstract**

A siphon cooler and a fin thereof. According to actual design requirements, the siphon cooler can only comprise the fin, or the siphon cooler can comprise both the fin and a heat sink fin. A compensation cavity with a Tesla valve structure is arranged inside a fin cavity of the fin, and one or more fluid loops are formed in cavities of a cooling base plate and the fin, such that a liquid working medium and a gaseous working medium flow smoothly in the fluid loops, thereby greatly improving the heat exchange efficiency. Thus, the problems whereby gaseous working media in cavities of the cooler increase and liquid working media therein decrease, such that internal pressure increases, and the gaseous working media may interfere with the liquid working media and occupy a space for reflux of the liquid working media, and the problem whereby the reflux of the liquid working media is not facilitated due to the liquid working media being affected by the gaseous working media and reflux resistance, thereby affecting heat transfer and heat dissipation effects are solved.

## Description

This application claims the priority of the Chinese Patent Application No. 202211429081.8, titled "SIPHON COOLER AND FIN THEREOF", filed on November 15, 2022 with the China National Intellectual Property Administration, which is incorporated herein by reference in its entirety.

### FIELD

The present application relates to the technical field of heat dissipation, and in particular to a siphon radiator and a heat dissipation member thereof.

### BACKGROUND

The honeycomb-shaped structures such as square, diamond and regular hexagon are mainly used in a cavity of a heat dissipation member of the conventional siphon radiator in order to promote the circulating flow of the working medium in the cavity. However, in performing the present application, it is found that the conventional technology has at least the following problems: with the increase of the power consumption of the heat source, if adopting the above honeycomb-shaped structures, the gas and liquid in the member cavity will flow in disorder in multiple directions due to the phase change of the working medium, and the gaseous working medium will interfere with the liquid working medium and occupy the space where the liquid working medium flows back, resulting in the liquid working medium is affected by the gaseous working medium and the backflow resistance, which is not conducive to the backflow of the liquid working medium and thus affects the heat dissipation effect.

### SUMMARY

In view of this, a siphon radiator and a heat dissipation member thereof is provided according to the present application, and a unidirectional flow structure is arranged in a member cavity, so that interference between gas working medium and liquid working medium is reduced, and the gas working medium and the liquid working medium flow in an orderly way, thus greatly improving efficiency of heat exchange.

A heat dissipation member is provided according to the present application, including a member cavity and a fluid port in communication with the member cavity, where the fluid port comprises a fluid inlet and a fluid outlet. The member cavity includes a flow guiding cavity and a compensation cavity formed by at least one unidirectional flow structure, where the flow guiding cavity has a flow guiding inlet and a flow guiding outlet, and the compensation cavity has a compensation cavity inlet and a compensation cavity outlet. The flow guiding inlet is in communication with the fluid inlet, the flow guiding outlet is in communication with the compensation cavity inlet, and the compensation cavity outlet is in communication with the fluid outlet.

In an embodiment, a solid part is further provided inside the member cavity, and the fluid inlet, the flow guiding cavity, the compensation cavity and the fluid outlet are sequentially in communication with each other to form a fluid loop, which is arranged around the solid part.

In an embodiment, the fluid inlet and the fluid outlet are arranged in a vertical direction and the fluid inlet is located above the fluid outlet, and the unidirectional flow structure is arranged at a bottom of the member cavity.

In an embodiment, the fluid inlet and the fluid outlet are arranged in a horizontal direction. The unidirectional flow structure is provided as a plurality of unidirectional flow structures arranged to be spaced apart from each other in the horizontal direction, and the flow guiding cavity extends upward between the multiple unidirectional flow structures and then extends in the horizontal direction.

In an embodiment, a distance between the two adjacent unidirectional flow structures gradually decreases in a direction away from the fluid port.

In an embodiment, the unidirectional flow structure is a Tesla valve
A siphon radiator is further provided according to the present application, including a heat dissipation substrate and at least one heat dissipation member as described above. The heat dissipation substrate includes a substrate cavity for reserving heat dissipation medium and is provided with a thermal-side end surface for connecting a heat source and a joint surface for connecting the heat dissipation member. The joint surface is provided with a connecting groove in communication with the substrate cavity, and the fluid port is connected to the connecting groove, and the substrate cavity is in communication with the member cavity.

In a preferred embodiment, the siphon radiator further includes at least one heat dissipation fin where the heat dissipation fin and the heat dissipation member are alternately arranged with each other.

In a preferred embodiment, the heat dissipation fin comprises a fin substrate, on which multiple concave-convex portions are arranged.

In a preferred embodiment, each of two opposite end portions of the fin substrate extends toward a same side to form a buckle edge.

In summary, a siphon radiator and a heat dissipation member thereof are provided according to the present application. A compensation cavity formed by a unidirectional flow structure is arranged in a member cavity of the heat dissipation member, and one or more fluid loops are formed in a cavity between a heat dissipation substrate and the heat dissipation member, so that the liquid working medium and the gaseous working medium flow smoothly in the fluid loop, and efficiency of heat exchange is greatly improved, thereby solving the problems that the gaseous working medium will interfere with the liquid working medium and occupy a space of its backflow, the liquid working medium is affected by the gaseous working medium and the backflow resistance, which is not conducive to the backflow of the liquid working medium and thus influences the effect of the heat transfer and heat dissipation.

### BRIEF DESCRIPTION OF THE DRAWINGS

FIG. 1 is a front view of a siphon radiator according to a first embodiment of the present application;
FIG 2 is a top view of the siphon radiator in FIG. 1;
FIG. 3 is a schematic view showing an internal structure of the siphon radiator in FIG. 1;
FIG. 4 is a schematic view showing an exploded structure of the siphon radiator in FIG. 1;
FIG. 5 is a schematic exploded view of a heat dissipation member in FIG. 1;
FIG 6 is a schematic view showing an internal structure of the heat dissipation member in FIG. 1;
FIG. 7 is a partial exploded schematic view of a heat dissipation fin unit in FIG. 1;
FIG. 8 is a side view of the heat dissipation fin unit in FIG. 1.
FIG. 9 is a schematic view showing an internal structure of a siphon radiator according to a second embodiment of the present application.
FIG. 10 is a schematic exploded view of the heat dissipation member in FIG. 9.
FIG. 11 is a schematic view showing an internal structure of the heat dissipation member in FIG. 9.
FIG. 12 is a schematic view showing a surface flow layer of the heat dissipation fin according to the present application in comparison with a surface flow layer of the existing heat dissipation fin.

### DETAILED DESCRIPTION OF THE EMBODIMENTS

Before describing the embodiments in detail, it should be understood that the present application is not limited to the details of construction or the arrangement of elements described in the following or in the drawings. The present application can be an embodiment realized in other ways. Moreover, it should be understood that the phraseology and terminology used herein are for the purpose of description only and should not be interpreted in a limiting way. Terms such as "comprise", "include", "have" and the like used herein are intended to include the items listed thereafter, their equivalents and other additional items. In particular, when "an element" is described, the number of the element is not limited to one, but may also include a plurality.

All directional terms (such as top, bottom, left, right, front, back, etc.) in the embodiments of the present application are only intended to illustrate a relative position relationship, relative motion, or the like between different components under a particular attitude (as shown in the drawings). The directional terms may change in case of a different attitude.

It should be noted that a horizontal direction and a vertical direction used in the present application are with reference to a direction in which a siphon radiator and a heat dissipation member are placed. In other words, the horizontal direction and the vertical direction used in the present application are defined with reference to the ground, where the vertical direction is the gravity direction, and the horizontal direction is a direction perpendicular to the vertical direction.

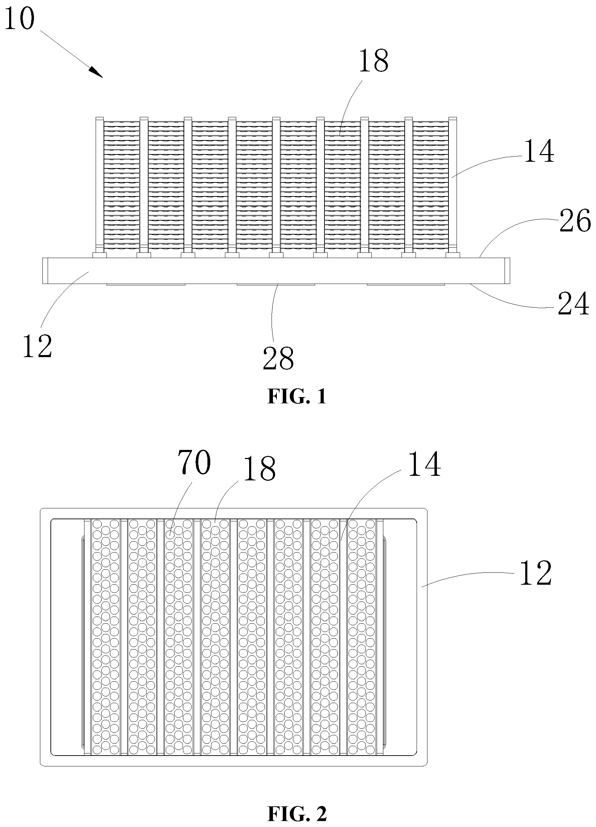

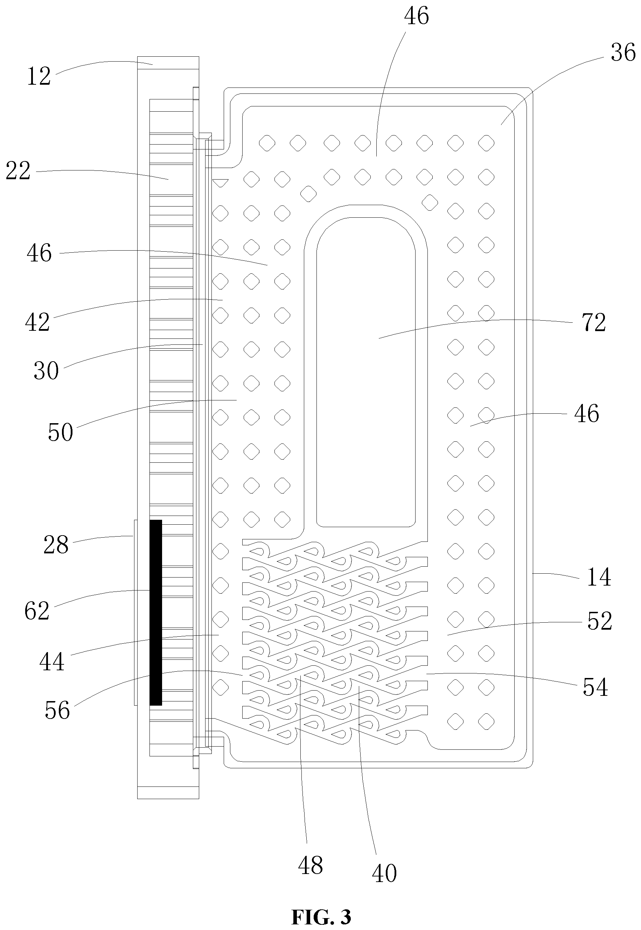

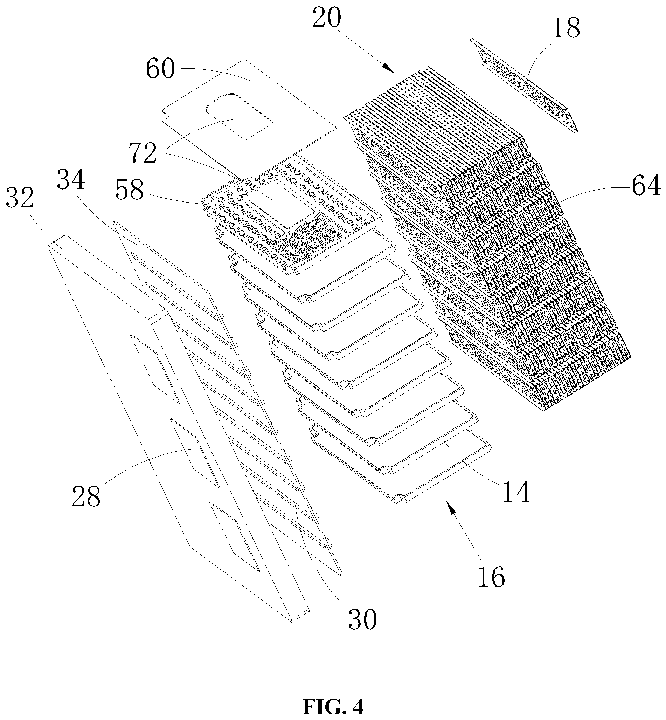

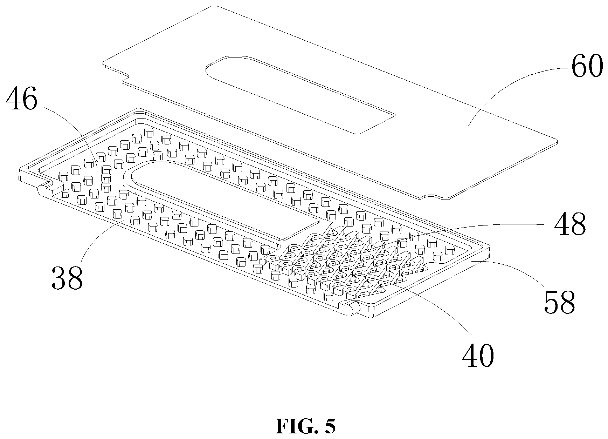

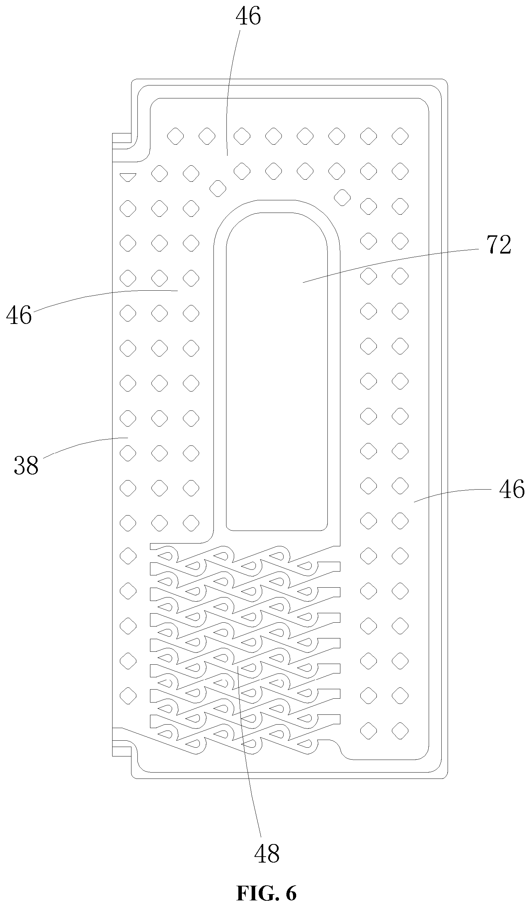

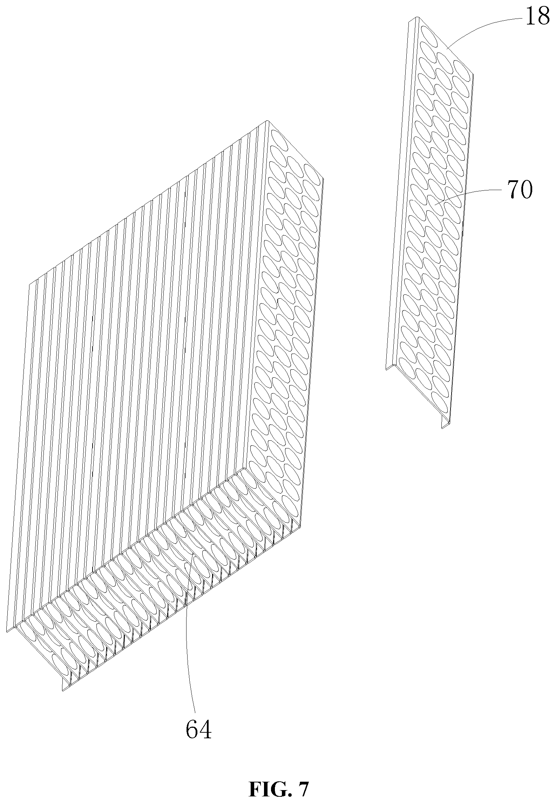

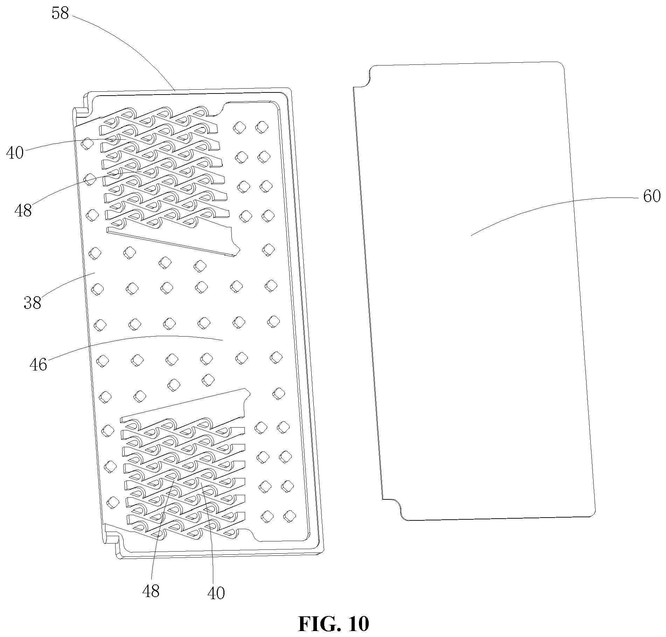

Referring to FIG. 1 to FIG. 12, a siphon radiator 10 is provided according to the present application. The siphon radiator 10 includes a heat dissipation substrate 12, a heat dissipation member group 16 composed of multiple heat dissipation members 14 and a heat dissipation fin group 20 composed of multiple heat dissipation fins 18. The heat dissipation fin group 20 can dissipate heat to ambient environment through forced air convection generated by a fan, thus improving efficiency of heat dissipation. It should be understood that, in other embodiments, the siphon radiator 10 may only include the heat dissipation substrate 12 and the heat dissipation member group 16 composed of multiple heat dissipation members 14 based on actual requirements for the heat dissipation, so that the siphon radiator 10 can be used in a condition of natural convection.

The heat dissipation substrate 12 includes a substrate cavity 22 for reserving heat dissipation medium, and the heat dissipation medium may be made of two-phase phase change materials such as R134a and R1233zd with high efficiency of heat exchange, which well solves the problems of a product being dry-out caused by insufficient heat dissipation of the product as power consumption of the product is too large and the heat flow density is too high. In this embodiment, the heat dissipation substrate 12 is in a square structure, including a thermal-side end surface 24 and a joint surface 26 opposite to each other. The thermal-side end surface 24 is configured for connecting a heat source, such as a CPU. The thermal-side end surface 24 may be provided with multiple CPU-heat source surfaces 28, for example three CPU-heat source surfaces 28, arranged at intervals in a length direction of the heat dissipation substrate 12. The heat dissipation member group 16 is connected to the joint surface 26. Specifically, the joint surface 26 is provided with multiple connecting grooves 30 in communication with the substrate cavity 22. The multiple connecting grooves 30 each extends in a width direction of the heat dissipation substrate 12, and the multiple connecting grooves 30 are arranged to be evenly spaced apart from each other in the length direction of the heat dissipation substrate 12 and in parallel to each other.

Optionally, the heat dissipation substrate 12 includes a base 32 and a cover plate 34 which are connected with each other, for example, by welding in aluminum brazing. The connecting grooves 30 are formed in the cover plate 34, and the substrate cavity 22 is formed between the base 32 and the cover plate 34.

The heat dissipation member 14 includes a member cavity 36 and a fluid port 38 in communication with the member cavity 36. In the illustrated embodiment, the heat dissipation member 14 is in a square structure. The member cavity 36 is provided with multiple columns extending along its thickness direction, where the columns may be in various shapes, and a cavity structure of the member cavity 36 is formed between the columns. The fluid port 38 includes a fluid inlet 42 and a fluid outlet 44, and a fluid loop communicating between the fluid inlet 42 and the fluid outlet 44 is formed in the member cavity 36. More specifically, the member cavity 36 includes a flow guiding cavity 46 and a compensation cavity 48, which is formed by at least one unidirectional flow structure. The flow guiding cavity 46 has a flow guiding inlet 50 and a flow guiding outlet 52, and the compensation cavity 48 has a compensation cavity inlet 54 and a compensation cavity outlet 56. The flow guiding inlet 50 is in communication with the fluid inlet 42, the flow guiding outlet 52 is in communication with the compensation cavity inlet 54, and the compensation cavity outlet 56 is in communication with the fluid outlet 44, thus forming a smooth fluid loop in the member cavity 36.

In the illustrated embodiment, the unidirectional flow structure is implemented as a Tesla valve 40. In other embodiments, the unidirectional flow structure may also be implemented as other structure that can realize unidirectional flow of the fluid, similar to the characteristics of the Tesla valve 40.

In one embodiment, the heat dissipation substrate 12 is provided with notches at both ends of the fluid port 38 to facilitate the connection of the heat dissipation member 14 to the heat dissipation substrate 12.

One end of the heat dissipation member 14 at the fluid port 38 is connected to the connecting groove 30, so that the substrate cavity 22 is in communication with the member cavity 36. The liquid heat dissipation medium in the substrate cavity 22, after absorbing heat, evaporates from the fluid port 38 and enters the member cavity 36. Since the Tesla valve 40 has the characteristic of unidirectional flow guiding, it is impossible for the evaporated gaseous heat dissipation medium entering the compensation cavity 48 through a part of the fluid port 38 corresponding to the Tesla valve 40 and then flowing into the flow guiding cavity 46 due to a significantly large resistance. Therefore, the evaporated gaseous heat dissipation medium can enter the member cavity 36 only through a part of the fluid port 38 corresponding to the flow guiding cavity 46, then flow to the compensation cavity 48 and then flow back to the substrate cavity 22 through the fluid port 38. As a result, the fluid port 38 according to the present application is divided into the fluid inlet 42 corresponding to the flow guiding cavity 46 and the fluid outlet 44 corresponding to the compensation cavity 48. The compensation cavity 48 adopts the characteristic of unidirectional flow guiding of the Tesla valve 40, which greatly improves a backflow rate and further enhancing the efficiency of heat exchange. However, the conventional heat dissipation members simply adopt square, diamond and regular hexagonal structures, which do not have this characteristic, and the gas and liquid therein are easy to be disordered, which affects the heat dissipation performance of the members.

In the present application, the cavity structure of the heat dissipation member 14 is designed in such a way that the flow of the heat dissipation medium in the fluid loop is very smooth and the heat dissipation performance is improved. It solves the problems of a decrease of the liquid heat dissipation working medium and an increase of internal pressure in the cavity of the phase-change radiator due to an increase of the gaseous heat dissipation working medium, and thus the gaseous heat dissipation working medium will interfere with the liquid heat dissipation working medium and occupy a space for backflow, and the liquid heat dissipation working medium is affected by the gaseous heat dissipation working medium and the backflow resistance, and thus the backflow of the liquid heat dissipation working medium is affected.

Optionally, the heat dissipation member 14 includes a member bottom plate 58 and a member cover plate 60 which are butt jointed with each other, for example, by welding in an aluminum brazing process. A member cavity 36 is formed between the member bottom plate 58 and the member cover plate 60.

Optionally, one end of the heat dissipation member 14 at the fluid port 38 is welded with a groove wall of the connecting groove 30 by the aluminum brazing process, so that the substrate cavity 22 is in communication with the member cavity 36 and forms an integrally closed cavity.

The heat dissipation member group 16 is welded with the joint surface 26 of the heat dissipation substrate 12. Specifically, the number of heat dissipation members 14 is set to be the same with the number of connecting grooves 30, and each of the heat dissipation members 14 is welded with one corresponding connecting groove 30.

In the illustrated embodiment, the substrate cavity 22 is further provided with a capillary structure 62 for absorbing the backflow of the liquid heat dissipation working medium. For example, the capillary structure 62 is attached to an inner wall of the base 32. The capillary structure 62 may be made of heat-conducting metal particles, so as to enhance boiling effect and backflow of the heat dissipation working medium and further improve the efficiency of heat dissipation.

In the present application, the siphon radiator 10 includes at least one heat dissipation fin unit 64, and the at least one heat dissipation fin unit 64 is arranged alternately with the heat dissipation member 14. In the illustrated embodiment, the siphon radiator 10 includes multiple heat dissipation fin units 64, which constitute the above heat dissipation fin group 20.

More specifically, the heat dissipation fin group 20 includes multiple heat dissipation fin units 64, each of which is connected between two adjacent heat dissipation members 14, and each of which is formed by jointing multiple heat dissipation fins 18.

In the illustrated embodiment, the heat dissipation fin 18 is in a square structure, including a fin substrate 66 and a buckle edge 68 extending from two opposite ends of the fin substrate 66 toward a same side of the fin substrate. The buckle edge 68 is arranged to be, for example, perpendicular to the fin substrate 66. Multiple heat dissipation fins 18 are stacked with each other and jointed together through the buckle edges 68 to form the heat dissipation fin unit 64, and multiple heat dissipation fin units 64 form the heat dissipation fin group 20. A distance between two adjacent fins 18 can be adjusted based on the actual design requirements, that is, a length of the buckle edge 68 can be adjusted. The heat dissipation fin 18 may be manufactured by stamping.

In an embodiment, the fin substrate 66 is provided with multiple concave-convex portions 70, each of which is convex on one side and concave on the other side, and the concave-convex portions 70 can cover the entire fin substrate 66. In the illustrated embodiment, the concave-convex portions 70 each is in a circular shape and protrudes toward the heat dissipation substrate 12. In the present application, the fin substrate 66 of the heat dissipation fin 18 is provided with concave-convex portions 70, which can be used for disturbing the flow to form turbulent flow and improve efficiency of heat dissipation.

Further, a diameter of the concave-convex portion 70 is 5mm, and a depth of a dent formed by the concave-convex portion 70 is 0.25mm. In other embodiments, a size of the concave-convex portion 70 can be different, which is not limited in the present application.

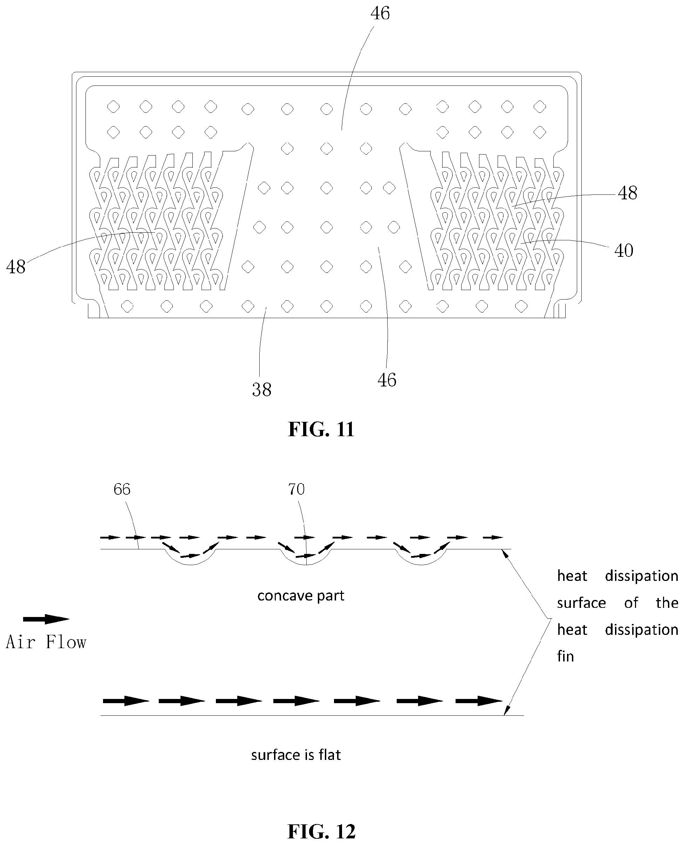

As shown in FIG. 12, the concave-convex portion 70 provided on the fin substrate 66 can increase a heat dissipation area of the heat dissipation fin 18, and the design of the concave-convex portion 70 can bring a turbulence effect to a surface of the fin substrate 66. When a forced air convection is generated in a region of the heat dissipation fin group 20 by the fan, the airflow forms turbulent flow on the surface of the fin substrate 66. Compared to the conventional fin whose two surfaces are flat, on which the airflow forms laminar flow that is mainly caused by intermolecular interaction, the turbulent flow is mainly caused by mixing of particles, and thus the heat transfer rate of the turbulent flow is much higher than that of laminar flow, so that the efficiency of heat dissipation is higher. Therefore, the design of the concave-convex portion 70 can greatly improve the efficiency of heat exchange.

The heat dissipation fin unit 64 is connected with two adjacent heat dissipation members 14 therebetween through the buckle edge 68 of each of the heat dissipation fins 18, for example, the buckle edge 68 is welded to the heat dissipation member 14 by the aluminum brazing process. For example, the fin substrate 66 is perpendicular to the heat dissipation member 14.

In the embodiment shown in FIG. 1 to FIG. 8, the heat dissipation substrate 12 is placed vertically, so that the flow guiding direction of the fluid port 38 is oriented horizontally, and the fluid inlet 42 and the fluid outlet 44 are arranged in the vertical direction. A solid part 72 is further provided in the member cavity 36, where the solid part 72 is configured in such a way that an annular cavity is formed in the member cavity 36, and the fluid loop is arranged around the solid part 72. The fluid inlet 42 is located above the fluid outlet 44, and the Tesla valve 40 is located in a bottom region of the member cavity 36.

In this embodiment, the capillary structure 62 is arranged on a region of an inner wall, corresponding to the Tesla valve 40, of the substrate cavity 22.

When the CPU-heat source surface 28 is heated, the liquid heat dissipation working medium in the substrate cavity 22 absorbs heat and vaporizes, then enters the member cavity 36 for heat exchange, and transfers the heat to the heat dissipation fin 18 at the same time. Under the forced convection generated by the fan, the heat from the heat dissipation fin 18 will be radiated to outside in the vertical direction, and the heat will be exchanged in the horizontal direction at the same time. The liquid heat dissipation working medium will flow into the substrate cavity 22 under an action of gravity and the compensation cavity 48, which circulates and dissipate heat away efficiently.

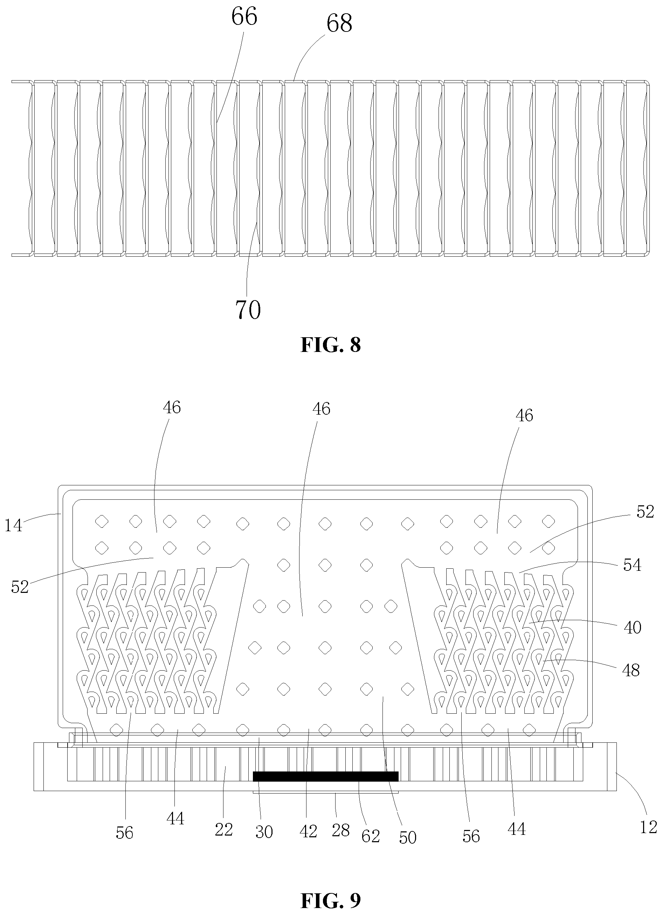

In the embodiment shown in FIG. 9 to FIG. 11, the heat dissipation substrate 12 is placed horizontally, so that the flow guiding direction of the fluid port 38 is in the vertical direction, and the fluid inlet 42 and the fluid outlet 44 are arranged in the horizontal direction. In case that the power of the device to be heat-dissipated increases and the number of the heat source location increases, the length of the heat dissipation member 14 can be increased. The number of the Tesla valves 40 may be more than one, and multiple Tesla valves 40 are distributed at intervals in the horizontal direction. The flow guiding cavity 46 extends upward between the multiple Tesla valves 40 and then extends in the horizontal direction so as to form a multi-cycle structure.

In this embodiment, the number of the Tesla valves 40 is two, and the two Tesla valves 40 are respectively mounted at the bottom of both sides in the member cavity 36. The evaporated gaseous heat dissipation working medium flows upward along the flow guiding cavity 46 between the two Tesla valves 40, then branches toward two opposite sides and flows downwards into the compensation cavities 48 at two opposite sides, and finally flows back into the substrate cavity 22, forming a double-cycle structure.

In an embodiment, the distance between the two Tesla valves 40 decreases gradually in the direction away from the fluid port 38. For example, the side walls, faced to each other, of the two Tesla valves 40 are arranged in inclined structure, so that the evaporated gaseous heat dissipation working medium can smoothly enter the compensation cavity 48 from the flow guiding cavity 46.

In this embodiment, the capillary structure 62 is arranged on a region of the inner wall, corresponding to a region between the two Tesla valves 40, of the substrate cavity 22.

When the CPU-heat source surface 28 is heated, the liquid heat dissipation working medium in the substrate cavity 22 absorbs heat and vaporizes, then enters the member cavity 36 for heat exchange, and transfers the heat to the heat dissipation fin 18 at the same time. The compensation cavity 48 is in an inclined structure, so that the evaporated gaseous heat dissipation working medium smoothly enters the compensation cavity 48 from the flow guiding cavity 46. Under the forced convection generated by the fan, the heat from the heat dissipation fin 18 will be radiated to outside in the horizontal direction while exchange heat in the vertical direction. The liquid heat dissipation working medium flows into the substrate cavity 22 under the action of gravity and the compensation cavity 48, which circulates and dissipates heat efficiently.

The specific working principle of the siphon radiator 10 according to the present application is as follows: when the siphon radiator 10 is in operation, the liquid heat dissipation working medium in the substrate cavity 22 of the heat dissipation substrate 12 begins to evaporate and enters the member cavity 36 through the fluid port 38. Since the Tesla valve 40 is in a unidirectional flow guiding structure, the evaporated gaseous heat dissipation working medium enters the flow guiding cavity 46 from the fluid inlet 42 through the flow guiding inlet 50. Due to the downward direction of gravity and the existence of the solid part 72 and the compensation cavity 48, the evaporated gaseous heat dissipation working medium smoothly enters the compensation cavity 48 from the flow guiding outlet 52 through the compensation cavity inlet 54, and flows back to the substrate cavity 22 from the compensation cavity outlet 56 through the fluid outlet 44 after being liquefied and cooled into a liquid state and will circulate in this way.

The siphon radiator 10 according to the present application has advantages over the conventional modular radiator under the condition of limited equipment space and increased equipment power, and can effectively solve the problems such as the conventional radiator being dried out. The compensation cavity 48 formed by the Tesla valve 40 is arranged in the heat dissipation member 14, so as to solve the problems that, due to an increase of the gaseous working medium, a decrease of the liquid working medium and an increase of internal pressure in the cavity of the phase-change radiator, the gaseous working medium will interfere with the liquid working medium and occupy a space of its backflow, and the liquid heat dissipation working medium is affected by the gaseous heat dissipation working medium and the backflow resistance, and thus the backflow of the liquid heat dissipation working medium is affected, which affect the heat-transferring and the efficiency thereof. The surface of the heat dissipation fin 18 is provided with concave-convex portions 70, which can disturb the flow to form turbulent flow and improve the efficiency of heat dissipation.

The siphon radiator 10, the heat dissipation member 14 and the heat dissipation fin 18 according to the present application each is made of aluminum, and all of the components are brazed by a special brazing jig after assembly. The product and the structure of the substrate and cavity of the radiator for the product in different scenes can work normally after brazing. After the CPU-heat source surface 28 is heated, the liquid heat dissipation working medium vaporizes in the substrate cavity 22 and enters the member cavity 36, and then transfers the heat to the heat dissipation fin 18, so as to dissipate heat to the ambient environment through the forced convection. It has a high reliability, a stable product structure and a good airtightness by adopting the mature brazing technology.

In some embodiments, the height of the member cavity 36 and/or the height of the substrate cavity 22 can be increased based on the actual design requirements, so as to obtain a larger cavity volume and facilitate the flow of the heat dissipation working medium.

In some embodiments, the compensation cavity 48, that is, the upper and lower locations of the Tesla valve 40 can be changed to match with the change of the heat source location based on the actual design requirements.

In some embodiments, the length, width and thickness of each of the heat dissipation fins 18 and the spacing between the heat dissipation fins 18 can be changed to adjust the impedance of the heat dissipation system of the siphon radiator 10 based on the actual design requirements.

In summary, a siphon radiator and a heat dissipation member thereof is provided according to the present application. A compensation cavity formed by a unidirectional flow structure is arranged in the member cavity of the heat dissipation member, and one or more fluid loops are formed in a cavity of a heat dissipation substrate and the heat dissipation member, so that the liquid working medium and the gaseous working medium can flow smoothly in the fluid loop, and efficiency of heat exchange is greatly improved, thereby solving the problems that, due to an increase of the gaseous working medium, a decrease of the liquid working medium and an increase of internal pressure in the cavity of the radiator, the gaseous working medium will interfere with the liquid working medium and occupy a space of its backflow, and the liquid working medium is affected by the gaseous working medium and the backflow resistance, which is not conducive to the backflow of the liquid working medium and influences the effect of the heat transfer and heat dissipation.

The concepts described herein can be implemented in other forms without departing from its spirit and characteristics. The specific embodiments disclosed should be considered as illustrative rather than limited. Therefore, the scope of the present application should be determined by the appended claims, rather than by the foregoing description. Any changes within the literal meaning and equivalent range of the claims should fall within the scope of these claims.

## Claims

1. A heat dissipation member, comprising:
a member cavity; and
a fluid port in communication with the member cavity, wherein
the fluid port comprises a fluid inlet and a fluid outlet;
the member cavity comprises a flow guiding cavity and a compensation cavity formed by at least one unidirectional flow structure;
the flow guiding cavity has a flow guiding inlet and a flow guiding outlet, and the compensation cavity has a compensation cavity inlet and a compensation cavity outlet; and
the flow guiding inlet is in communication with the fluid inlet, the flow guiding outlet is in communication with the compensation cavity inlet, and the compensation cavity outlet is in communication with the fluid outlet.

2. The heat dissipation member according to claim 1, wherein a solid part is further provided inside the member cavity, and the fluid inlet, the flow guiding cavity, the compensation cavity and the fluid outlet are sequentially in communication with each other to form a fluid loop; and
the fluid loop is arranged around the solid part.

3. The heat dissipation member according to claim 1, wherein the fluid inlet and the fluid outlet are arranged in a vertical direction, the fluid inlet is located above the fluid outlet, and the at least one unidirectional flow structure is arranged at a bottom of the member cavity.

4. The heat dissipation member according to claim 1, wherein the fluid inlet and the fluid outlet are arranged in a horizontal direction; and
the number of the at least one unidirectional flow structure is plural, the plurality of the unidirectional flow structures are arranged to be spaced apart from each other in the horizontal direction, and the flow guiding cavity extends upward between the plurality of unidirectional flow structures and then extends in the horizontal direction.

5. The heat dissipation member according to claim 4, wherein a distance between the two adjacent unidirectional flow structures gradually decreases in a direction away from the fluid port.

6. The heat dissipation member according to any one of claims 1 to 5, wherein the at least one unidirectional flow structure is a Tesla valve.

7. A siphon radiator, comprising a heat dissipation substrate and at least one heat dissipation member according to any one of claims 1 to 6, wherein the heat dissipation substrate comprises a substrate cavity for reserving heat dissipation medium and is provided with a thermal-side end surface for connecting a heat source and a joint surface for connecting the heat dissipation member, and wherein the joint surface is provided with a connecting groove in communication with the substrate cavity, the fluid port is connected to the connecting groove, and the substrate cavity is in communication with the member cavity.

8. The siphon radiator according to claim 7, further comprising at least one heat dissipation fin, wherein the at least one heat dissipation fin and the at least one heat dissipation member are alternately arranged with each other.

9. The siphon radiator according to claim 8, wherein each of the at least one heat dissipation fin comprises a fin substrate, on which a plurality of concave-convex portions are provided.

10. The siphon radiator according to claim 9, wherein each of two opposite end portions of the fin substrate extends toward a same side to form a buckle edge.
